# EUROPÄISCHE PATENTSCHRIFT

(11) **EP 0 577 623 B1**
(45) Veröffentlichungstag und Bekanntmachung des Hinweises auf die Patenterteilung: **27.05.1998**
(21) Anmeldenummer: 92905762.8
(22) Anmeldetag: 05.03.1992
(51) Int. Cl.: H01L 29/74, H01L 29/32, H01L 31/111, H01L 21/263, H01L 29/10

(54) **Verfahren zur Herstellung eines Thyristors mit einstellbarer Kippspannung**
Method of making a thyristor with adjustable breakover voltage
Méthode de fabrication d'un thyristor à tension de retournement ajustable

(30) Priorität: 27.03.1991 DE 4110099
(43) Veröffentlichungstag der Anmeldung: 12.01.1994
(73) Patentinhaber: SIEMENS AKTIENGESELLSCHAFT, 80333 München (DE)
(72) Erfinder: SCHULZE, Hans-Joachim, D-85521 Ottobrunn (DE); MITLEHNER, Heinz, D-80798 München (DE); PFIRSCH, Frank, D-81545 München (DE)
(86) Internationale Anmeldenummer: DE9200191
(87) Internationale Veröffentlichungsnummer: WO9217907

(56) Entgegenhaltungen:
- EP-A- 343 369
- EP-A- 423 721
- DE-A- 3 151 138
- FR-A- 2 144 581
- RECORD OF THE 16TH ANNUAL IEEE POWER ELECTRONICS SPECIALISTS CONFERENCE 1985
- Juni 1985, TOULOUSE, FRANKREICH Seiten 463 - 468; J. X. PRZYBYSZ: 'LASER TRIMMING OF THYRISTORS TO ADD AN OVERVOLTAGE SELF-PROTECTED TURN-ON FEATURE'

## Beschreibung

Die Erfindung bezieht sich auf Verfahren zur Herstellung eines Thyristors mit einstellbarer Kippspannung.

Wenn eine zwischen der kathodenseitigen und anodenseitigen Elektrode eines Thyristors anliegende, den Thyristor blockierende Spannung den Wert der Kippspannung (breakover voltage) erreicht oder übersteigt, so erfolgt ein lokaler Durchbruch des die p-Basis von der n-Basis trennenden pn-Übergangs. Im allgemeinen tritt der Durchbruch an dem in der Seitenfläche des Thyristors liegenden Rand dieses pn-Übergangs auf. Zur Vermeidung eines solchen sehr häufig zur Zerstörung des Thyristors führenden lokalen Durchbruchs ist es aus der EP-A-0 088 967 bekannt, den pn-Übergang zwischen der p-Basis und der n-Basis durch Bestrahlung mit einem Laserstrahl unterhalb des zentralen Zündkontakts des Thyristors mit einer die Dicke der n-Basisschicht verringernden Ausbuchtung zu versehen und damit bereits bei einer reduzierten Kippspannung einen kontrollierbaren Durchbruch herbeizuführen, der im Bereich der Ausbuchtung auftritt. Dieser kontrollierbare Durchbruch führt zu einer Überkopf zündung des Thyristors, bei der eine thermische Zerstörung wegen der kontrollierbaren Zündausbreitung sicher vermieden wird. Nachteilig ist jedoch, daß die reduzierte Kippspannung hierbei nicht mit der gewünschten Genauigkeit und Reproduzierbarkeit auf einen bestimmten Spannungswert eingestellt werden kann.

Aus der EP-A-0 316 881 ist es andererseits bekannt, die Kippspannung eines Thyristors dadurch einzustellen, daß ein Teilbereich seines p-Emitters, der im lateralen Bereich eines Zündkontakts oder einer lichtempfindlichen Thyristorzone angeordnet ist, eine höhere Dotierungskonzentration erhalt als die übrigen Teile des p-Emitters.

Ferner ist aus der europäischen Patentanmeldung EP-A-0 343 369 A1 ein Verfahren zum Herstellen eines Thyristors bekannt, bei dem mit Hilfe einer lokalen Protonenbestrahlung in einem Bereich eine geringere Durchbruchsspannung erzeugt wird als im übrigen Halbleiterkörper des Thyristors, wobei die Protonenenergie so bemessen wird, daß das Maximum der durch die Protonen erzeugten Störstellendichte zwischen dem Übergang von erster Basiszone zur Zeiten Basis zone und der halben Dicke der zweiten Basiszone liegt.

Weiter ist aus der nachveröffentlichten Patentanmeldung EP-A-0 423 721 A2, die einen Prioritätstag vor dem Anmeldetag der vorliegenden Anmeldung aufweist, unter anderem ein Verfahren zur Einstellung der Kippspannung bekannt, bei dem durch Dosisvariation einer Protonenstrahlung die Anzahl von Kristalldefekten in einer Basisschicht verändert wird, um die Kippspannung definiert einzustellen.

Der vorliegenden Erfindung liegt die Aufgabe zugrunde, einen Thyristor herzustellen, bei dem der pn-Übergang zwischen der p-Basis und der n-Basis beim Erreichen einer einstellbaren, reduzierten Kippspannung in definierter Weise durchbricht, ohne daß hierdurch eine thermische Zerstörung eintritt, wobei die zur Einstellung der reduzierten Kippspannung getroffenen Maßnahmen in einfacher Weise durchzuführen sind. Das wird erfindungsgemäß durch ein Verfahren gemäß irgendeinem der unabhängigen Ansprüche 1 bis 3 erreicht.

Der mit der Erfindung erzielbare Vorteil liegt insbesondere darin, daß die reduzierte Kippspannung, bei der der pn-Übergang zwischen der p-Basis und der n-Basis des Thyristors durchbricht, ohne daß dieser hierdurch Schaden erleidet, durch den in einfacher Weise wählbaren Abstand der mit den Generations- und Rekombinationszentren versehenen Zone von der kathodenseitigen Hauptfläche mit hinreichender Genauigkeit und Reproduzierbarkeit eingestellt werden kann.

Die Ansprüche 4 und 5 sind auf bevorzugte Weiterbildungen der Erfindung gerichtet.

Die Erfindung wird nachfolgend anhand der Zeichnung näher erläutert. Dabei zeigt:
- Figur 1: einen nach der Erfindung hergestellten Thyristor,
- Figur 2: eine Darstellung zur Erläuterung eines ersten erfindungsgemäßen Verfahrens,
- Figur 3: eine andere Darstellung zur Erläuterung des ersten erfindungsgemäßen Verfahrens,
- Figur 4: ein zweites erfindungsgemäßes Verfahren und
- Figur 5: ein drittes erfindungsgemäßes Verfahren.

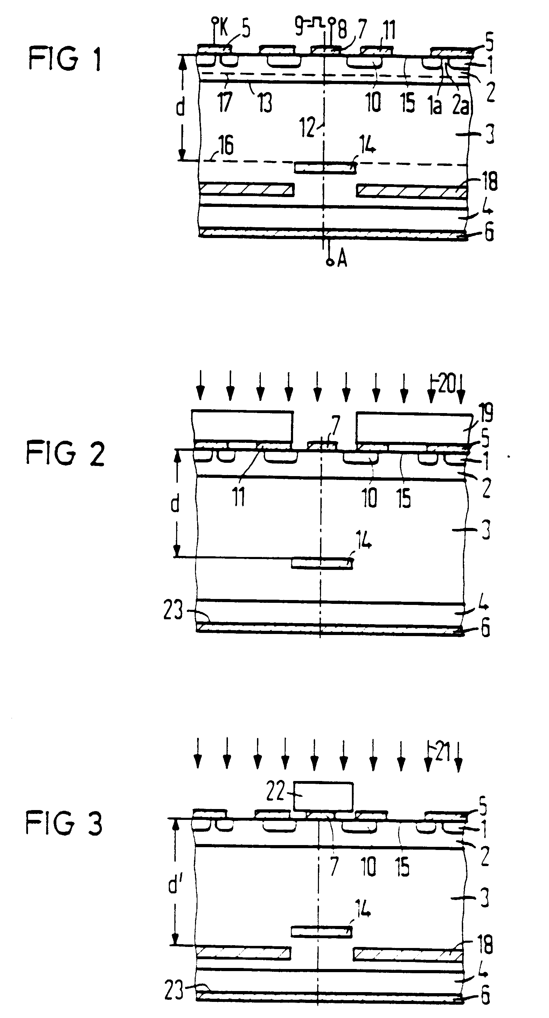

In Figur 1 ist ein Leistungsthyristor dargestellt, der einen Halbleiterkörper, zum Beispiel aus dotiertem Silizium, mit vier aufeinanderfolgenden Halbleiterschichten alternierender Leitfähigkeitstypen aufweist. Im einzelnen bestehen diese aus einem n-Emitter 1, einer p-Basis 2, einer n-Basis 3 und einem p-Emitter 4. Der n-Emitter 1 wird von einer mit einem Anschluß K versehenen, kathodenseitigen Elektrode 5 kontaktiert, der p-Emitter 4 von einer anodenseitigen Elektrode 6, die mit einem Anschluß A versehen ist. Ein bei A und K angeschlossener, im einzelnen nicht dargestellter äußerer Stromkreis enthält prinzipiell eine Spannungsquelle, die zum Beispiel eine Gleichspannung von 1000 Volt abgibt, und einen in Serie zu dieser liegenden Arbeitswiderstand. Dabei wird die anodenseitige Elektrode 6 durch die von der Spannungsquelle gelieferte Spannung auf ein gegenüber K positives Potential gelegt, so daß sich der Thyristor im blockierten Zustand befindet.

Ein die p-Basis 2 kontaktierender Zündkontakt 7 ist mit einem Anschluß 8 versehen, dem ein mit 9 bezeichneter, positiver Spannungsimpuls zugeführt wird, um den Thyristor zu zünden. Wird der sich im blockierenden Zustand befindende Thyristor hierdurch in den stromführenden Zustand übergeführt, so schließt er den äußeren Stromkreis durch eine niederohmige Verbindung zwischen A und K. Das Löschen des Thyristors, das heißt sein Übergang aus dem stromführenden in den gesperrten Zustand, erfolgt beispielsweise durch eine Abschaltung der genannten Spannungsquelle oder für den Fall, daß es sich bei dieser um eine Wechselspannungsquelle handelt, beim ersten nach der Zündung auftretenden Nulldurchgang der gelieferten Wechselspannung.

Ein in die p-Basis 2 eingefügtes n-leitendes Gebiet 10 ist mit einer leitenden Belegung 11 versehen, die in Richtung auf den n-Emitter 1 soweit verlängert ist, daß sie den pn-Übergang zwischen 10 und 2 kurzschließt. Die Teile 10 und 11 bilden einen sogenannten Hilfsemitter (amplifying gate) der eine innere Zündverstärkung des Thyristors darstellt. Bei rotationssymmetrischem Aufbau des Thyristors ist die strichpunktierte Linie 12 als Symmetrieachse anzusehen. Mit la sind Ausnehmungen des n-Emitters 1 bezeichnet, die von entsprechenden Ansätzen 2a der p-Basis 2 ausgefüllt werden. Letztere werden von der kathodenseitigen Elektrode 5 kontaktiert. Die Teile la und 2a bilden Emitter-Basis-Kurzschlüsse, die eine unerwünschte Zündung des Thyristors beim Anlegen von Blockierspannungen verhindern.

Zwischen der p-Basis 2 und der n-Basis 3 befindet sich ein pn-Ubergang 13, der beim Anlegen einer Blockierspannung an die Anschlüsse A und K in Sperrichtung vorgespannt wird. Erhöht man diese Blockierspannung auf den Wert der Kippspannung, so führt ein dann entstehender lokaler Durchbruch des pn-Übergangs 13 zu einer unkontrollierbaren Zündung des Thyristors, die diesen thermisch zerstören kann.

Um diese Gefahr zu beseitigen, ist durch maskierte Bestrahlung mit geladenen Teilchen eine Zone 14 der n-Basis, die sich im lateralen Bereich des Zündkontakts 7 oder bei einem lichtzündbaren Thyristor im lateralen Bereich einer lichtempfindlichen Thyristorzone befindet und etwa parallel zur kathodenseitigen Hauptfläche 15 verläuft, mit zusätzlichen Generations- und Rekombinationszentren versehen. Die geladenen Teilchen, die vorzugsweise aus Protonen oder Heliumkernen bestehen, erzeugen Defekte im Halbleitergitter, welche die Trägerlebensdauer herabsetzen. Unter dem Einfluß der an A und K anliegenden Blockierspannung bildet sich am pn-Übergang 13 eine Raumladungszone aus, deren Breite sich mit ansteigender Blockierspannung vergrößert. Der Abstand der Zone 14 von der kathodenseitigen Hauptfläche 15 wird nun so gewählt, daß dann, wenn die Blockierspannung den Wert einer gewünschten reduzierten Kippspannung erreicht hat, die untere Grenze der Raumladungszone mit der oberen Grenzfläche der Zone 14 gerade zusammenfällt. Für diesen Wert der Blockierspannung sind die Grenzen der Raumladungszone in Figur 1 eingezeichnet, wobei die untere Grenze mit 16 und die obere Grenze mit 17 bezeichnet sind. Beim Erreichen der reduzierten Kippspannung zündet der Thyristor, da die Verstärkung der aus den Schichten 4, 3 und 2 gebildeten pnp-Transistorstruktur im lateralen Bereich des Zündkontakts 7 schlagartig stark erhöht wird. Dies geschieht wegen des durch die Zone 14 stark erhöhten Generationsstroms in der Raumladungszone 16, 17. Das Zusammentreffen der Raumladungszonengrenze 16 mit der Zone 14, in der eine erhöhte Generation und Rekombination von Ladungsträgern stattfindet, bewirkt also die Überkopfzündung des Thyristors. Die reduzierte Kippspannung, bei der es hierzu kommt, wird durch den Abstand d der Zone 14 von der kathodenseitigen Hauptfläche 15 in einfacher Weise eingestellt.

Die kontrollierbare Zündung des Thyristors beim Erreichen der reduzierten Kippspannung kann bei einer variablen Einstellbarkeit der elektrischen Thyristordaten auch dadurch gesichert werden, daß durch Bestrahlung mit geladenen Teilchen in der n-Basis 3 zusätzlich eine weitere Zone 18 mit Rekombinationszentren erzeugt wird, die sich außerhalb des lateralen Bereichs der Zone 14 befindet und sich ebenso wie diese parallel zur kathodenseitigen Hauptfläche erstreckt. Die Zone 18 ist dabei in einem größeren Abstand von der kathodenseitigen Hauptfläche 15 angeordnet als die Zone 14. Durch die Zone 18 wird die Rekombination in dem außerhalb der Zone 14 liegenden lateralen Bereich der n-Basis 3 vergrößert, was eine Einstellbarkeit zum Beispiel der Durchlaßspannung und der Speicherladung des Thyristors erlaubt und außerdem bewirkt, daß die Differenz der Verstärkung der pnp-Teiltransistoren in den Bereichen der Zone 14 und der Zone 18 weiter anwächst. Die in die Zone 18 eingebrachten geladenen Teilchen bestehen ebenfalls aus Protonen oder Heliumkernen.

Der Thyristor nach Figur 1 ist aber auch ohne die Zone 18 voll funktionsfähig.

Die Herstellung eines Thyristors, der zwar die Zone 14, nicht aber die Zone 18 enthält, soll nun anhand von Figur 2 beschrieben werden. Dabei wird von einem aus den Teilen 1 bis 6, 10 und 11 bestehenden Thyristor herkömmlicher Bauweise ausgegangen. Die kathodenseitige Hauptfläche 15 wird außerhalb eines zentralen Bereichs, der für den Zündkontakt 7 oder bei einem lichtempfindlichen Thyristor für eine lichtempfindliche Thyristorzone vorgesehen ist, durch eine Maske 19, zum Beispiel aus Metall, vollständig abgedeckt. Dann erfolgt eine Bestrahlung des Thyristors mit geladenen Teilchen, zum Beispiel Protonen oder Heliumkernen, in Richtung der Pfeile 20. Dabei stehen diese unter dem Einfluß einer Beschleunigungsspannung, deren Größe so gewählt wird, daß die Teilchen mit einer kinetischen Energie beaufschlagt werden, welche sie bis zu einer dem Abstand d entsprechenden Eindringtiefe in den Halbleiterkörper eintreibt. Dort entsteht dann die mit Generations- und Rekombinationszentren angereicherte Zone 14 der n-Basis 3. Der Abstand d wird in erster Linie durch die Größe der Beschleunigungsspannung bestimmt, ohne daß die eingestrahlte Protonendosis, die pro cm² etwa bei 10¹⁰ liegen kann, eine kritische Rolle spielen würde.

Will man erfindungsgemäß den auf diese Weise hergestellten Thyristor noch mit der Zone 18 versehen, so wird gemäß Figur 3 in einem weiteren Verfahrensschritt eine zusätzliche Bestrahlung des Thyristors durch seine kathodenseitige Hauptfläche 15 mit geladenen Teilchen der genannten Art vorgenommen, was durch die Pfeile 21 angedeutet ist. Dabei wird eine Maske 22, zum Bespiel aus Metall, verwendet, die zur Maske 19 invers ausgebildet ist und somit nur den zentralen Teil, der für einen Zündkontakt 7 oder für eine lichtempfindliche Thyristorzone vorgesehen ist, abdeckt. Durch Anwendung einer Beschleunigungsspannung, die größer ist als die zur Erzeugung der Zone 14 verwendete, dringen die geladenen Teilchen tiefer in den Halbleiterkörper ein, so daß in einem Abstand d' von der kathodenseitigen Hauptfläche 15 eine Zone 18 der n-Basis 3 entsteht, die mit den geladenen Teilchen angereichert ist. Die Zone 18 liegt dann in dem außerhalb der Zone 14 befindlichen lateralen Bereich des Thyristors. Der Abstand d' ist größer als der Abstand d gemäß Figur 2.

Das vorstehend beschriebene, erfindungsgemäße Verfahren kann auch in der Weise abgeändert werden, daß die Bestrahlung des Thyristors mit den geladenen Teilchen durch seine anodenseitige Hauptfläche 23 hindurch erfolgt. Dabei werden in den Figuren 2 und 3 die Masken 19 und 22 jeweils zur Abdeckung der anodenseitigen Hauptfläche 23 verwendet und die Bestrahlungsrichtungen entsprechend umgekehrt, so daß die geladenen Teilchen durch die Hauptfläche 23 in den Thyristor eindringen. In diesem Fall wird die Beschleunigungsspannung zur Erzeugung der Zone 14 größer gewählt als die zur Erzeugung der Zone 18, um zu der bereits beschriebenen Größenrelation von d und d' zu gelangen.

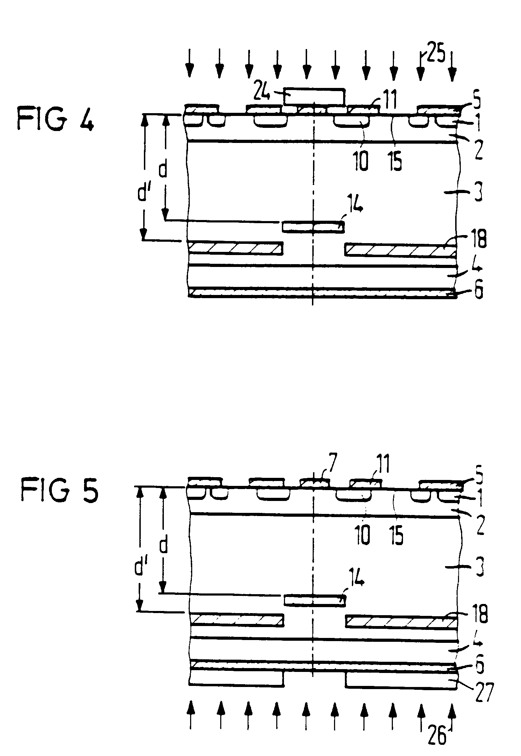

Ein anderes erfindungsgemäßes Verfahren zur Herstellung eines Thyristors, der die Zonen 14 und 18 aufweist, besteht gemäß Figur 4 darin, daß von einem die Teile 1 bis 6, 10 und 11 enthaltenden Thyristor ausgegangen wird und eine ganzflächige kathodenseitige Bestrahlung desselben mit geladenen Teilchen, zum Beispiel Protonen oder Heliumkernen, erfolgt, wobei an die Stelle der Maske 22 von Figur 3 eine dieser in ihren lateralen Abmessungen entsprechende Blende 24 tritt. Diese Bestrahlung wird durch die Pfeile 25 angedeutet. Die geladenen Teilchen stehen hierbei unter dem Einfluß einer Beschleunigungsspannung, die sie mit einer solchen kinetischen Energie beaufschlagt, daß sie außerhalb des lateralen Bereichs der Blende 24 eine Eindringtiefe d' erreichen, wobei die mit den geladenen Teilchen angereicherte Zone 18 entsteht. Gleichzeitig absorbiert die Blende 24 bei den auf sie treffenden geladenen Teilchen einen solchen Teil der kinetischen Energie, daß die die Blende 24 durchdringenden Teilchen eine kinetische Restenergie aufweisen, durch die sie eine Eindringtiefe d erreichen. Auf diese Weise wird unterhalb der Blende 24 die Zone 14 im Abstand d von der kathodenseitigen Hauptfläche 15 gebildet.

Ein weiteres erfindungsgemäßes Verfahren zur Herstellung eines Thyristors mit den Zonen 14 und 18 wird anhand von Figur 5 beschrieben. Es besteht darin, daß ein die Teile 1 bis 6, 10 und 11 enthaltender Thyristor durch seine anodenseitige Grenzfläche 23 ganzflächig mit den bereits beschriebenen geladenen Teilchen bestrahlt wird, was durch die Pfeile 26 angedeutet ist. Dabei wird eine Blende 27 vorgesehen, die zur Blende 24 invers ist, das heißt den gesamten lateralen Bereich außerhalb eines für den Zündkontakt 7 oder für eine lichtempfindliche Thyristorzone vorgesehenen, zentralen Bereichs vollständig abdeckt. Die geladenen Teilchen stehen dabei unter dem Einfluß einer Beschleunigungsspannung, die sie innerhalb dieses zentralen Bereichs eine solche Eindringtiefe erreichen läßt, daß die Zone 14 im Abstand d von der kathodenseitigen Hauptfläche gebildet wird. Gleichzeitig absorbiert die Blende 27 bei den auf sie treffenden Teilchen einen solchen Teil der kinetischen Energie, daß die die Blende 27 durchdringenden Teilchen eine kinetische Restenergie aufweisen, durch die sie eine Eindringtiefe erreichen, welche dem Abstand d' von der kathodenseitigen Hauptfläche 15 entspricht. Hierbei entsteht im lateralen Bereich der Blende 27 die Zone 18.

Sieht man in den Verfahren gemäß den Figuren 4 oder 5 Blenden 24 bzw. 27 vor, die aus einem Halbleitermaterial gefertigt sind, das dem Material des Halbleiterkörpers entspricht, so kann die gewünschte Größenrelation von d und d' in vorteilhafter Weise dadurch erzielt werden, daß die Dicke der Blenden 24 und 27 der Differenz d' - d entspricht.

Bei einem erfindungsgemäß hergestellten Thyristor können die zur inneren Zündverstärkung dienenden Teile 10 und 11 auch entfallen. Weiterhin kann bei der Herstellung des Thyristors gemäß den Figuren 2 und 3 auch der in Figur 3 angedeutete Verfahrensschritt vor dem in Figur 2 angedeuteten vorgenommen werden.

## Patentansprüche

1. Verfahren zur Herstellung eines Thyristors mit einem Halbleiterkörper mit einer kathodenseitigen Hauptfläche (15) und einer anodenseitigen Hauptfläche (23), der einen von einer kathodenseitigen Elektrode (5) kontaktierten n-Emitter (1) mit einer angrenzenden p-Basis (2) und einen von einer anodenseitigen Elektrode (6) kontaktierten p-Emitter (4) mit einer angrenzenden n-Basis (3) aufweist, die ihrerseits durch einen pn-Übergang (13) von der p-Basis (2) getrennt ist, der eine Zone (14) der n-Basis (3) aufweist, die in einem zentralen Bereich des Halbleiterkörpers angeordnet ist, der sich unterhalb eines Zündkontaktes (7) oder einer lichtempfindlichen Thyristorzone befindet, etwa parallel zur kathodenseitigen Hauptfläche (15) verläuft und mit zusätzlichen Generations- und Rekombinationszentren versehen ist,
bei dem der den n-Emitter (1), die p-Basis (2), die n-Basis (3) und den p-Emitter (4) umfassende Halbleiterkörper zur Erzeugung der Zone (14) der n-Basis (3) unter Anwendung einer Metallmaske (19), die eine der Hauptflächen (15) außerhalb des zentralen Bereichs vollständig abdeckt, durch diese Hauptfläche (15) mit geladenen unter dem Einfluß einer Beschleunigungsspannung stehenden Teilchen bestrahlt wird,
bei dem die Teilchen im zentralen Bereich in den Halbleiterkörper eindringen und dort in der Zone (14) der n-Basis (3) die zusätzlichen Generations- und Rekombinationszentren bewirken,
bei dem durch die gewählte Beschleunigungsspannung ein Abstand (d) der Zone (14) der n-Basis (3) zur kathodenseitigen Hauptfläche (15) und damit die Kippspannung des Thyristors eingestellt wird,
bei dem der Halbleiterkörper zur Erzeugung einer weiteren Zone (18) in der n-Basis (3) mit zusätzlich eingebrachten Rekombinationszentren unter Anwendung einer weiteren Metallmaske (22), die den zentralen Bereich der Hauptfläche (15) abdeckt, durch diese Hauptfläche (15) mit geladenen Teilchen bestrahlt wird, wobei die letzteren unter dem Einfluß einer zweiten Beschleunigungsspannung stehen, die sie mit einer den Abstand (d') der weiteren Zone (18) der n-Basis von der kathodenseitigen Hauptfläche (15) bestimmenden, kinetischen Energie beaufschlagt, wobei der Abstand (d') zwischen der kathodenseitigen Hauptfläche (15) und der weiteren Zone (18) der n-Basis größer ist als der Abstand (d) zwischen der kathodenseitigen Hauptfläche (15) und der Zone (14) der n-Basis.

2. Verfahren zur Herstellung eines Thyristors mit einem Halbleiterkörper mit einer kathodenseitigen Hauptfläche (15) und einer anodenseitigen Hauptfläche (23), der einen von einer kathodenseitigen Elektrode (5) kontaktierten n-Emitter (1) mit einer angrenzenden p-Basis (2) und einen von einer anodenseitigen Elektrode (6) kontaktierten p-Emitter (4) mit einer angrenzenden n-Basis (3) aufweist, die ihrerseits durch einen pn-Ubergang (13) von der p-Basis (2) getrennt ist, mit einer Zone (14) der n-Basis (3), die in einem zentralen Bereich des Halbleiterkörpers angeordnet ist, der sich unterhalb eines Zündkontaktes (7) oder einer lichtempfindlichen Thyristorzone befindet, etwa parallel zur kathodenseitigen Hauptfläche (15) verläuft, zusätzlich Generations- und Rekombinationszentren aufweist und in einem den Wert der Kippspannung des Thyristors bestimmenden Abstand (d) von der kathodenseitigen Hauptfläche (15) angeordnet ist,
bei dem der den n-Emitter (1), die p-Basis (2), die n-Basis (3) und den p-Emitter (4) umfassende Halbleiterkörper zur Erzeugung der Zone (14) der n-Basis (3) und einer weiteren Zone (18) der n-Basis (3) kathodenseitig mit geladenen Teilchen bestrahlt wird,
bei dem die Teilchen im zentralen Bereich in den Halbleiterkörper eindringen und dort in der Zone (14) der n-Basis (3) die zusätzlichen Generations- und Rekombinationszentren bewirken,
bei dem eine den zentralen Bereich der kathodenseitigen Hauptfläche (15) abdeckende Blende (24) vorgesehen wird,
bei dem die geladenen Teilchen unter dem Einfluß einer Beschleunigungsspannung stehen, die sie mit einer den Abstand (d') der weiteren Zone (18) der n-Basis von der kathodenseitigen Hauptfläche (15) bestimmenden kinetischen Energie beaufschlagt und
bei dem die Blende (24) einen solchen Teil der kinetischen Energie absorbiert, daß die die Blende (24) durchdringenden geladenen Teilchen eine den Abstand (d) der Zone (14) der n-Basis (3) von der kathodenseitigen Hauptfläche (15) bestimmende kinetische Restenergie aufweisen und durch den Abstand (d) der Zone (14) der n-Basis im zentralen Bereich die Kippspannung eingestellt wird, wobei der Abstand (d') zwischen der kathodenseitigen Hauptfläche (15) und der weiteren Zone (18) der n-Basis größer ist als der Abstand (d) zwischen der kathodenseitigen Hauptfläche (15) und der Zone (14) der n-Basis.

3. Verfahren zur Herstellung eines Thyristors mit einem Halbleiterkörper mit einer kathodenseitigen Hauptfläche (15) und einer anodenseitigen Hauptfläche (23), der einen von einer kathodenseitigen Elektrode (5) kontaktierten n-Emitter (1) mit einer angrenzenden p-Basis (2) und einen von einer anodenseitigen Elektrode (6) kontaktierten p-Emitter (4) mit einer angrenzenden n-Basis (3) aufweist, die ihrerseits durch einen pn-Ubergang (13) von der p-Basis (2) getrennt ist, mit einer Zone (14) der n-Basis (3), die in einem zentralen Bereich des Halbleiterkörpers angeordnet ist, der sich unterhalb eines Zündkontaktes (7) oder einer lichtempfindlichen Thyristorzone befindet, etwa parallel zur kathodenseitigen Hauptfläche (23) verläuft, zusätzlich Generations- und Rekombinationszentren aufweist und in einem den Wert der Kippspannung des Thyristors bestimmenden Abstand (d) von der kathodenseitigen Hauptfläche (23) angeordnet ist,
bei dem der den n-Emitter (1), die p-Basis (2), die n-Basis (3) und den p-Emitter (4) umfassende Halbleiterkörper zur Erzeugung der Zone (14) der n-Basis (3) und einer weiteren Zone (18) der n-Basis (3) anodenseitig mit geladenen Teilchen bestrahlt wird,
bei dem die Teilchen im zentralen Bereich in den Halbleiterkörper eindringen und dort in der Zone (14) der n-Basis (3) die zusätzlichen Generations- und Rekombinationszentren bewirken,
bei dem eine Blende (27) vorgesehen wird, die die anodenseitige Hauptfläche (23) außerhalb des zentralen Bereichs vollständig abdeckt,
bei dem die geladenen Teilchen unter dem Einfluß einer Beschleunigungsspannung stehen, die sie mit einer den Abstand (d) der Zone (14) der n-Basis von der kathodenseitigen Hauptfläche (15) bestimmenden kinetischen Energie beaufschlagt und durch den Abstand (d) der Zone (14) der n-Basis im zentralen Bereich die Kippspannung eingestellt wird und
bei dem die Blende (27) einen solchen Teil der kinetischen Energie absorbiert, daß die die Blende (27) durchdringenden geladenen Teilchen eine den Abstand (d') der weiteren Zone (18) der n-Basis von der kathodenseitigen Hauptfläche (15) bestimmende kinetische Restenergie aufweisen, wobei der Abstand (d') zwischen der kathodenseitigen Hauptfläche (15) und der weiteren Zone (18) der n-Basis größer ist als der Abstand (d) zwischen der kathodenseitigen Hauptfläche (15) und der Zone (14) der n-Basis.

4. Verfahren nach Anspruch 2 oder 3,
**dadurch gekennzeichnet,**
daß die Blende (24, 27) aus dem gleichen Halbleitermaterial besteht wie der Halbleiterkörper und daß diese Blende eine Dicke aufweist, die dem gegenseitigen Abstand der Zone (14) der n-Basis (3) und der weiteren Zone (18) entspricht.

5. Verfahren zur Herstellung eines Thyristors nach einem der vorhergehenden Ansprüche,
**dadurch gekennzeichnet,**
daß die geladenen Teilchen aus Protonen oder Heliumkernen bestehen.

## Claims

1. Process for manufacturing a thyristor with a semiconductor body having a cathode-end main surface (15) and an anode-end main surface (23), which exhibits an n-type emitter (1), which is in contact with a cathode-end electrode (5), with an adjoining p-type base (2), and a p-type emitter (4), which is in contact with an anode-end electrode (6), with an adjoining n-type base (3) which, in turn, is separated from the p-type base (2) by a pn junction (13), which exhibits a zone (14) of the n-type base (3) which is arranged in a central area of the semiconductor body which is located underneath a triggering contact (7) or a light-sensitive thyristor zone, extends approximately in parallel with the cathode-end main surface (15) and is provided with additional generation and recombination centres,
in which the semiconductor body comprising the n-type emitter (1), the p-type base (2), the n-type base (3) and the p-type emitter (4), for the purpose of generating the zone (14) of the n-type base (3), using a metal mask (19) which completely covers one of the main surfacess (15) outside the central area, is irradiated with charged particles which are under the influence of an accelerating voltage through this main surface (15), in which the particles penetrate into the semiconductor body in the central area and there produce the additional generation and recombination centres in the zone (14) of the n-type base (3), in which a distance (d) of the zone (14) of the n-type base (3) from the cathode-end main surface (15), and thus the breakover voltage of the thyristor, is set by means of the selected accelerating voltage, in which the semiconductor body, for the purpose of generating a further zone (18) in the n-type base (3) with additionally inserted recombination centres, using a further metal mask (22) which covers the central area of the main surface (15), is irradiated with charged particles through this main surface (15), the charged particles being under the influence of a second accelerating voltage which imparts to them a kinetic energy determining the distance (d') of the further zone (18) of the n-type base from the cathode-end main surface (15), the distance (d') between the cathode-end main surface (15) and the further zone (18) of the n-type base being greater than the distance (d) between the cathode-end main surface (15) and the zone (14) of the n-type base.

2. Process for manufacturing a thyristor with a semiconductor body having a cathode-end main surface (15) and an anode-end main surface (23), which exhibits an n-type emitter (1), which is in contact with a cathode-end electrode (5), with an adjoining p-type base (2), and a p-type emitter (4), which is in contact with an anode-end electrode (6), with an adjoining n-type base (3) which, in turn, is separated from the p-type base (2) by means of a pn junction (13), with a zone (14) of the n-type base (3) which is arrranged in a central area of the semiconductor body which is located underneath a triggering contact (7) or a light-sensitive thyristor zone, extends approximately in parallel with the cathode-end main surface (15), additionally exhibits generation and recombination centres and is arranged at a distance (d) from the cathode-end main surface (15) determining the value of the breakover voltage of the thyristor, in which the semiconductor body comprising the n-type emitter (1), the p-type base (2), the n-type base (3) and the p-type emitter (4), for the purpose of generating the zone (14) of the n-type base (3) and a further zone (18) of the n-type base (3), is irradiated with charged particles at the cathode end, having a cathode-end main surface (15) and an anode-end main surface (23), in which a shutter (24) covering the central area of the cathode-end main surface (15) is provided,
in which the charged particles are under the influence of an accelerating voltage which imparts to them a kinetic energy determining the distance (d') of the further zone (18) of the n-type base from the cathode-end main surface (15),
and in which the shutter (24) absorbs such a proportion of the kinetic energy that the charged particles penetrating through the shutter (24) exhibit a residual kinetic energy determining the distance (d) of the zone (14) of the n-type base (3) from the cathode-end main surface (15) and the breakover voltage is set by the distance of the zone (14) in the central area, the distance (d') between the cathode-end main surface (15) and the further zone (18) of the n-type base being greater than the distance (d) between the cathode-end main surface (15) and the zone (14) of the n-type base.

3. Process for manufacturing a thyristor with a semiconductor body having a cathode-end main surface (15) and an anode-end main surface (23), which exhibits an n-type emitter (1), which is in contact with a cathode-end electrode (5), with an adjoining p-type base (2), and a p-type emitter (4), which is in contact with an anode-end electrode (6), with an adjoining n-type base (3) which, in turn, is separated from the p-type base (2) by means of a pn junction (13), with a zone (14) of the n-type base (3) which is arrranged in a central area of the semiconductor body which is located underneath a triggering contact (7) or a light-sensitive thyristor zone, extends approximately in parallel with the cathode-end main surface (15), additionally exhibits generation and recombination centres and is arranged at a distance (d) from the cathode-end main surface (15) determining the value of the breakover voltage of the thyristor, in which the semiconductor body comprising the n-type emitter (1), the p-type base (2), the n-type base (3) and the p-type emitter (4), for the purpose of generating the zone (14) of the n-type base (3) and a further zone (18) of the n-type base (3), is irradiated with charged particles at the anode end, having a cathode-end main surface (15) and an anode-end main surface (23), in which a shutter (27) is provided, which shutter completely covers the anode-end main surface (23) outside the central area,
in which the charged particles are under the influence of an accelerating voltage which imparts to them a kinetic energy determining the distance (d) of the zone (14) of the n-type base from the cathode-end main surface (15) and the breakover voltage is set by the distance (d) of the zone (14) of the n-type base in the central area, and in which the shutter (27) absorbs such a proportion of the kinetic energy that the charged particles penetrating the shutter (27) exhibit a residual kinetic energy determining the distance (d') of the further zone (18) of the n-type base from the cathode-end main surface (15), the distance (d') between the cathode-end main surface (15) and the further zone (18) of the n-type base being greater than the distance (d) between the cathode-end main surface (15) and the zone (14) of the n-type base.

4. Process according to claim 2 or 3, characterized in that the shutter (24, 27) consists of the same semiconductor material as the semiconductor body, and in that this shutter exhibits a thickness which corresponds to the mutual distance of the zone (14) of the n-type base (3) and the further zone (18).

5. Process for manufacturing a thyristor according to one of the preceding claims, characterized in that the charged particles consist of protons or helium nuclcei.

## Revendications

1. Méthode de fabrication d'un thyristor comprenant un corps semi-conducteur avec une surface principale (15) côté cathode et une surface principale (23) côté anode, qui présente un émetteur N (1) mis en contact par une électrode (5) côté cathode avec une base P (2) contiguë et un émetteur P (4) mis en contact par une électrode (6) côté anode avec une base N (3) contiguë séparée de son côté de la base P (2) par une jonction PN (13), qui présente une zone (14) de la base N (3), disposée dans une partie centrale du corps semi-conducteur, qui se trouve au-dessous d'un contact d'amorçage (7) ou d'une zone photosensible du thyristor, s'étend sensiblement parallèlement à la surface principale (15) côté cathode et est pourvue de centres de génération et de recombinaison supplémentaires,
dans laquelle le corps semi-conducteur comprenant l'émetteur N (1), la base P (2), la base N (3) et l'émetteur P (4) est exposé aux radiations de particules chargées à travers cette surface principale (15) se trouvant sous l'influence d'une tension accélératrice, en appliquant un masque métallique (19) recouvrant entièrement l'une (15) des surfaces principales en dehors de la partie centrale, pour créer la zone (14) de la base N (3),
dans laquelle les particules pénètrent dans la partie centrale dans le corps semi-conducteur, où elles créent dans la zone (14) de la base N (3) les centres de génération et de recombinaison supplémentaires,
dans laquelle on règle par la tension accélératrice choisie une distance (d) de la zone (14) de la base N (3) par rapport à la surface principale (15) côté cathode et, par là, la tension de retournement du thyristor,
dans laquelle, pour créer une autre zone (18) dans la base N (3) comprenant des centres de recombinaison supplémentaires, en appliquant un autre masque métallique (22) recouvrant la partie centrale de la surface principale (15), le corps semi-conducteur est exposé à travers cette surface principale (15) aux radiations de particules chargées, ces dernières étant sous l'influence d'une deuxième tension accélératrice qui leur fournit une énergie cinétique déterminant la distance (d') de l'autre zone (18) de la base N par rapport à la surface principale (15) côté cathode, la distance (d') entre la surface principale (15) côté cathode et l'autre zone (18) de la base N étant plus grande que la distance (d) entre la surface principale (15) côté cathode et la zone (14) de la base N.

2. Méthode de fabrication d'un thyristor constitué d'un corps semi-conducteur avec une surface principale (15) côté cathode et une surface principale (23) côté anode, qui présente un émetteur N (1) mis en contact par une électrode (5) côté cathode avec une base P (2) contiguë et un émetteur P (4) mis en contact par une électrode (6) côté anode avec une base N (3) contiguë séparée de son côté de la base P (2) par une jonction PN (13), avec une zone (14) de la base N (3), disposée dans une partie centrale du corps semi-conducteur, qui se trouve au-dessous d'un contact d'amorçage (7) ou d'une zone photosensible du thyristor, s'étend sensiblement parallèlement à la surface principale (15) côté cathode, comporte en plus des centres de génération et de recombinaison et est disposée à une distance (d) de la surface principale (15) côté cathode, qui détermine la valeur de la tension de retournement du thyristor,
dans laquelle le corps semi-conducteur comprenant l'émetteur N (1), la base P (2), la base N (3) et l'émetteur P (4), pour créer la zone (14) de la base N (3) et une autre zone (18) de la base N (3), est exposé côté cathode aux radiations de particules chargées,
dans laquelle les particules pénètrent, dans la partie centrale, dans le corps semi-conducteur, où elles créent dans la zone (14) de la base N (3) les centres de génération et de recombinaison supplémentaires,
dans laquelle un écran (24) est prévu, qui recouvre la partie centrale de la surface principale (15) côté cathode,
dans laquelle les particules chargées sont sous l'influence d'une tension accélératrice qui leur fournit une énergie cinétique déterminant la distance (d') de l'autre zone (18) de la base N par rapport à la surface principale (15) côté cathode,
dans laquelle l'écran (24) absorbe une telle partie de l'énergie cinétique que les particules chargées traversant l'écran (24) possèdent une énergie cinétique résiduelle déterminant la distance (d) de la zone (14) de la base N (3) par rapport à la surface principale (15) côté cathode, et dans laquelle on règle la tension de retournement par la distance (d) de la zone (14) de la base N dans la partie centrale, la distance (d') entre la surface principale (15) côté cathode et l'autre zone (18) de la base N étant plus grande que la distance (d) entre la surface principale (15) côté cathode et la zone (14) de la base N.

3. Méthode de fabrication d'un thyristor constitué d'un corps semi-conducteur avec une surface principale (15) côté cathode et une surface principale (23) côté anode, qui présente un émetteur N (1) mis en contact par une électrode (5) côté cathode avec une base P (2) contiguë et un émetteur P (4) mis en contact par une électrode (6) côté anode avec une base N (3) contiguë séparée de son côté de la base P (2) par une jonction PN (13), avec une zone (14) de la base N (3), disposée dans une partie centrale du corps semi-conducteur, qui se trouve au-dessous d'un contact d'amorçage (7) ou d'une zone photosensible du thyristor, s'étend sensiblement parallèlement à la surface principale (23) côté cathode, comporte en plus des centres de génération et de recombinaison et est disposée à une distance (d) de la surface principale (23) côté cathode, qui détermine la valeur de la tension de retournement du thyristor,
dans laquelle le corps semi-conducteur comprenant l'émetteur N (1), la base P (2), la base N (3) et l'émetteur P (4), pour créer la zone (14) de la base N (3) et une autre zone (18) de la base N (3), est exposé côté anode aux radiations de particules chargées,
dans laquelle les particules pénètrent, dans la partie centrale, dans le corps semi-conducteur, où elles créent dans la zone (14) de la base N (3) les centres de génération et de recombinaison supplémentaires,
dans laquelle un écran (27) est prévu, qui recouvre entièrement la surface principale (23) côté anode en dehors de la partie centrale,
dans laquelle les particules chargées sont sous l'influence d'une tension accélératrice qui leur fournit une énergie cinétique déterminant la distance (d) de la zone (14) de la base N par rapport à la surface principale (15) côté cathode, et dans laquelle on règle la tension de retournement par la distance (d) de la zone (14) de la base N dans la partie centrale,
dans laquelle l'écran (27) absorbe une telle partie de l'énergie cinétique que les particules chargées traversant l'écran (27) possèdent une énergie cinétique résiduelle déterminant la distance (d') de l'autre zone (18) de la base N par rapport à la surface principale (15) côté cathode, la distance (d') entre la surface principale (15) côté cathode et l'autre zone (18) de la base N étant plus grande que la distance (d) entre la surface principale (15) côté cathode et la zone (14) de la base N.

4. Méthode selon la revendication 2 ou 3, caractérisée en ce que l'écran (24, 27) est constitué du même matériau semi-conducteur que le corps semi-conducteur et en ce que cet écran a une épaisseur correspondant à la distance entre la zone (14) de la base N (3) et l'autre zone (18).

5. Méthode de fabrication d'un thyristor selon l'une des revendications précédentes, caractérisée en ce que les particules chargées sont composées de protons ou d'hélions.
